# EUROPEAN PATENT APPLICATION

(11) **EP 2 482 086 A1**
(43) Date of publication of application: **01.08.2012**
(21) Application number: 10818401.1
(22) Date of filing: 20.09.2010
(51) Int. Cl.: G01R 22/06, G01R 21/06, G08C 17/02, G08C 19/00

(54) **POWER METERING AUTOMATIC PRODUCT WITH COMMUNICATION FUNCTION**

(30) Priority: 23.09.2009 CN 200910175143
(71) Applicant: Guangzhou Sunrise Electronics Development Co., Ltd, Guangzhou, Guangdong 510300 (CN)
(72) Inventor: TENG, Chungui, Guangzhou Guangdong 510300 (CN); QU, Xinfeng, Guangzhou Guangdong 510300 (CN)
(74) Representative: Hervius Löthman, Johan
(86) International application number: PCT/CN2010/077131
(87) International publication number: WO 2011/035707

(57) **Abstract**

A power metering automatic product with communication function comprises a data collector (101), a data processor (102), a memory (103 and a communication module (104.The data collector (101) is used to collect signals of current and voltage. The data processor (102 is used to transform the signals of current and voltage collected by the data collector (101) into power data of quantity of electricity and load. The memory (103 is used to memorize the power data of quantity of electricity and load transformed by the data processor (102). The communication module (104 is used to transmit the power data of quantity of electricity and load memorized in the memory (103 to a power system server (2) according to the control requirements of the data processor (102).The product is used to acquire the power data collected by a power metering automatic product in time.

## Description

This application claims the priority of Chinese Patent Application No.200910175143.5, entitled "POWER METERING AUTOMATIC PROCUCT WITH COMMUNICATION FUCTION" filed on September 23, 2009 with State Intellectual Property Office of PRC, which is incorporated herein by reference in its entirety.

### FIELD OF THE PRESENT INVENTION

The present invention relates to the field of electric power system, and particularly to an automatic electric power metering product with communication function.

### BACKGROUND OF THE PRESENT INVENTION

An automatic electric power metering product is installed to a terminal of a user by electric power department, in order to obtain the data generated in use by the user, such as power consumption and loads.

In the specific application of the existing automatic electric power metering product, if it is necessary to obtain the electric power data, such as electricity quantity and loads, recorded by the automatic electric power metering product, the stuff of the electric power department must read the electric power data on the actual spot where the automatic electric power metering product is arranged. The electric power data recorded by the existing automatic electric power metering product, such as electricity quantity and loads, cannot be obtained remotely by the stuff of the electric power department in time, causing the difficulty in dispatching power in the electric power system.

In the existing automatic electric power metering product, since the electric power data, such as electricity quantity and loads, must be read by the stuff of the electric power department on the actual spot, there are three disadvantages below.

Firstly, it is inconvenient to obtain the electric power data, and the labor cost for obtaining data is thus increased.

Secondly, it is impossible for the electric power department to monitor in real time.

Thirdly, it is impossible for electric power department to analyze the electric power data effectively and to perform the power dispatching of the electric power system effectively.

Therefore, the technical problem to be solved by those skilled in the art is to provide an automatic electric power metering product, so as to obtain the electric power data, such as electricity quantity and loads, collected by the automatic electric power metering product in time.

### SUMMARY OF THE PRESENT INVENTION

The object of the present invention is to provide an automatic electric power metering product with communication function, so as to obtain the electric power data collected by the automatic electric power metering product in time.

An automatic electric power metering product with communication function is provided by the present invention, which includes:
a data collector adapted to collect a current signal and a voltage signal;
a data processor adapted to convert the current signal and the voltage signal collected by the data collector into electric power data of electricity quantity and loads;
a memory adapted to store the electric power data of electricity quantity and loads converted by the data processor; and
a communication module adapted to send the electric power data of electricity quantity and loads stored in the memory to a server of an electric power system according to control requirements of the data processor.

Preferably, the product further includes a timer connected to the data processor, and the communication module sends the electric power data of electricity quantity and loads stored in the memory to the server of the electric power system at a predetermined time interval for recording of the timer.

Preferably, the predetermined time interval is set as required.

Preferably, the communication module sends the electric power data of electricity quantity and loads stored in the memory to the server of the electric power system by wireless communication.

Preferably, the communication module sends the electric power data of electricity quantity and loads to the server of the electric power system with an SIM card.

Preferably, the memory is implemented with an SD card.

Preferably, the automatic electric power metering product is an electricity meter.

In the automatic electric power metering product with communication function according to the embodiment of the present invention, the data collector for collecting a current signal and a voltage signal is included, the current signal and the voltage signal collected by the data collector are converted into electric power data of electricity quantity and loads by the data processor and are stored by the memory, and then the communication module sends the electric power data of electricity quantity and loads stored in the memory to the server of the electric power system. Thus, the data recorded by the automatic electric power metering product according to the embodiment of the present invention may be sent to the power department as required, so that the power department may analyze the electric power data and perform the power dispatching in time.

### BRIEF DESCRIPTION OF THE DRAWINGS

Fig. 1 is an exploded perspective view of an automatic electric power metering product with communication function according to an embodiment of the present invention;

Fig. 2 is a structural perspective view of a communication module according to an embodiment of the present invention;

Fig. 3 is a structural view of an automatic electric power metering product with communication function according to an embodiment of the present invention.

### DETAILED DESCRIPTION OF THE PRESENT INVENTION

The present invention provides an automatic electric power metering product with communication function, for obtaining electric power data collected by the automatic electric power metering product in time.

Hereinafter, the present invention will be described in detail in conjunction with the drawings in order to better understand the structure and the working principle of an automatic electric power metering product with communication function according to embodiments of the present invention for those skilled in the art.

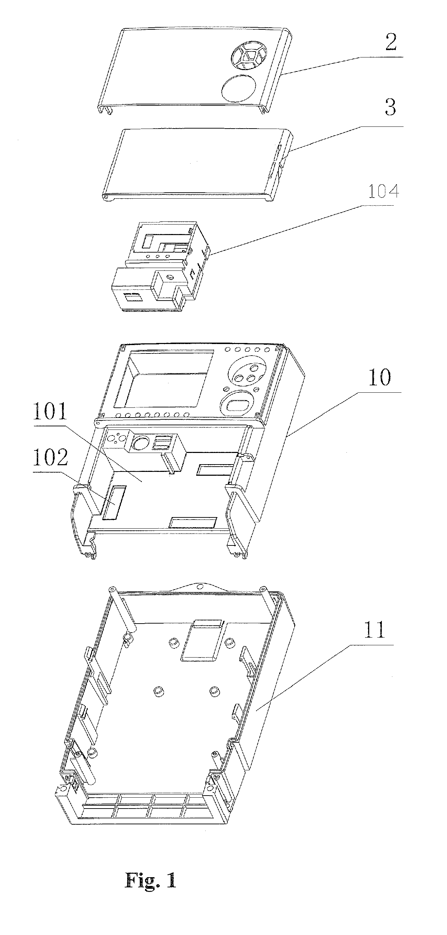

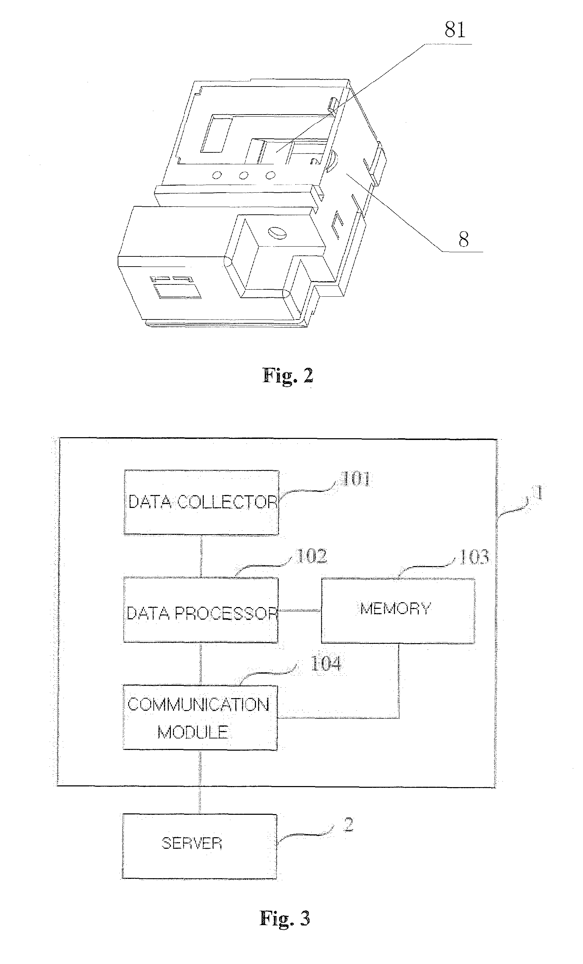

Referring to Figs. 1 to 3, Fig. 1 is an exploded perspective view of an automatic electric power metering product with communication function according to an embodiment of the present invention; Fig. 2 is a structural perspective view of a communication module according to an embodiment of the present invention; and Fig. 3 is a structural view of an automatic electric power metering product with communication function according to an embodiment of the present invention.

The automatic electric power metering product 1 with communication function according to the embodiment of the present invention includes a data collector 101, a data processor 102, a memory 103 and a communication module 104.

The data collector 101 is adapted to collect a current signal and a voltage signal.

Specifically, the data collector 101 is used to collect a current signal and a voltage signal of an external load.

The data processor 102 is adapted to convert the current signal and the voltage signal collected by the data collector 101 into electric power data of electricity quantity and loads.

The data processor 102 may be a processor in the existing automatic electric power metering product, as long as the current signal and the voltage signal can be converted into electric power data of electricity quantity and loads.

The memory 103 is adapted to store the electric power data of electricity quantity and loads converted by the data processor 102.

Specifically, the memory 103 may be implemented with an SD card.

A card slot for installing the SD card is provided inside the automatic electric power metering product 1 with communication function. The SD card is used to store the electric power data of electricity quantity and loads converted by the data processor 102.

The communication module 104 is adapted to send, according to control requirements of the data processor 102, the electric power data of electricity quantity and loads stored in the memory 103 to a server 2 of an electric power system.

Specifically, the communication module 104 may send, by wireless communication, the electric power data of electricity quantity and loads to the server of the electric power system.

Specifically, the communication module 104 may send the electric power data of electricity quantity and loads with an SIM card through a communication network to the server of the electric power system.

A card slot may be provided in the communication module 104 to accommodate the SIM card. The SIM card can receive and send a signal. Since the communication module 104 includes a SIM card, the real-time data transmission may be realized.

In the automatic electric power metering product 1 with communication function according to the embodiment of the present invention, the data collector 101 for collecting a current signal and a voltage signal is included, the current signal and the voltage signal collected by the data collector 101 are converted into electric power data of electricity quantity and loads by the data processor 102 and are stored by the memory 103, and then the communication module 104 sends the electric power data of electricity quantity and loads stored in the memory 103 to the server 2 of the electric power system. Thus, the data recorded by the automatic electric power metering product 1 with communication function according to the embodiment of the present invention may be sent to the power department as required, so that the power department may analyze the electric power data and perform the power dispatching in time.

The automatic electric power metering product 1 with communication function according to the embodiment of the present invention may further include a timer (not shown) connected to the data processor 102.

The communication module 104 sends the electric power data of electricity quantity and loads stored in the memory 103 to the server 2 of the electric power system at a predetermined time interval for recording of the timer.

The predetermined time interval of the timer may be set according to the requirements of the power department, which may specifically be 1-20 minutes. For ensuring the timeliness of the statistics, the predetermined time interval is specifically 1 minute.

The structure of the automatic electric power metering product 1 according to the embodiment of the present invention will be described in detail in conjunction with Fig. 1.

The automatic electric power metering product 1 with communication function according to the embodiment of the present invention includes a housing and a cavity with a predetermined shape arranged in the housing. A bottom plate of the cavity is provided with a through hole. A main board is arranged between a bottom plate of the housing and the bottom plate of the cavity. The cavity is adapted to accommodate the communication module 104 connected to the main board (not shown) through the through hole.

The housing includes a bottom shell 11 and a top cover 10. A cavity 101 with a predetermined shape is provided in the housing, and a bottom plate of the cavity 101 is provided with through holes 102. A main board (a main circuit board, not shown) of the automatic electric power metering product according to the embodiment of the present invention is arranged between the bottom plate of the housing (i.e. the bottom shell 11) and the bottom plate of the cavity 101. The data collector 101, the data processor 102, the memory 103 and the communication module 104 are connected to the circuit board.

The shape of the communication module 104 is matched with the predetermined shape of the cavity 101. The shape of the communication module 104 is shown in Fig. 1, and the cross section of the communication module 104 may substantially be rectangular. The communication module 104 includes protrusions (not shown) engaged with the through holes 102. Each of the protrusions may be of a plug-in structure or a slot structure.

The cross section of each through hole 102 is rectangular. The communication module 104 includes protrusions (not shown) engaged with the rectangular through holes 102. In the case that each protrusion is of a plug-in structure, the main board is provided with a slot structure engaged with the plug-in structure of the protrusion, at a location corresponding to the rectangular through hole 102. Specifically, the slot structure of the main board may include a plurality of sockets, while the plug-in structure of the protrusion may include a plug engaged with the socket. The number of the sockets may be larger than or equal to that of the plugs.

In the case that each protrusion is of a slot structure, the main board is provided with a plug-in structure engaged with the slot structure of the protrusion, at a location corresponding to the rectangular through hole 102. The plug-in structure of the main board may include a plurality of plugs, while the slot structure of the protrusion may include a socket engaged with the plug. The number of the plugs may be larger than or equal to that of the sockets.

Specifically, the automatic electric power metering product 1 with communication function may be a terminal automatic electric power metering product such as an electricity meter.

The above is only the preferred embodiments of the automatic electric power metering product with communication function according to the invention, and is not intend to limit the protection scope of the present invention. Any modification, equivalent concepts and improvement made within the spirit and principle of the present invention should be deemed to fall into the protection scope defined by claims of the present invention.

## Claims

1. An automatic electric power metering product with communication function, comprising:
a data collector adapted to collect a current signal and a voltage signal;
a data processor adapted to convert the current signal and the voltage signal collected by the data collector into electric power data of electricity quantity and loads;
a memory adapted to store the electric power data of electricity quantity and loads converted by the data processor; and
a communication module adapted to send the electric power data of electricity quantity and loads stored in the memory to a server of an electric power system according to control requirements of the data processor.

2. The automatic electric power metering product with communication function according to claim 1, further comprising a timer connected to the data processor, wherein the communication module sends the electric power data of electricity quantity and loads stored in the memory to the server of the electric power system at a predetermined time interval for recording of the timer.

3. The automatic electric power metering product with communication function according to claim 2, wherein the predetermined time interval is set as required.

4. The automatic electric power metering product with communication function according to claim 1, wherein the communication module sends the electric power data of electricity quantity and loads to the server of the electric power system by wireless communication.

5. The automatic electric power metering product with communication function according to claim 4, wherein the communication module sends the electric power data of electricity quantity and loads to the server of the electric power system with an SIM card.

6. The automatic electric power metering product with communication function according to claim 1, wherein the memory is implemented with an SD card.

7. The automatic electric power metering product with communication function according to claim 1, wherein the automatic electric power metering product is an electricity meter.
